# EUROPEAN PATENT APPLICATION

(11) **EP 1 398 638 A1**
(43) Date of publication of application: **17.03.2004**
(21) Application number: 02256246.6
(22) Date of filing: 10.09.2002
(51) Int. Cl.: G01R 21/02

(54) **Power measurement apparatus and method thereof**

(71) Applicant: Agilent Technologies, Inc. - a Delaware corporation -, Palo Alto, CA 94303-0870 (US)
(72) Inventor: Paterson, Eric, Agilent Technologies UK Ltd, West Lothian EH30 9TG, Scotland (GB)
(74) Representative: Coker, David Graeme

(57) **Abstract**

In order to detect and measure the power of radio or microwave frequency signals it is known to employ thermoelectric devices such as a thermistor or a thermocouple. Such thermoelectric devices can have slow response times and lask sensitivity due to "thermal lag" and poor conduction between a load resistor and the thermoelectric device. The present invention therefore provides an apparatus for the measurement of a power of a radio or microwave frequency signal (40) comprising a resistive element (14) for generating a thermal emission (42) in response to an incident signal and an infra-red photodetector (16) arranged to receive the thermal emission and thereby generate an output signal corresponding to the power of the incident signal. The present invention obviates or at least mitigates the disadvantages associated with known thermoelectric devices.

## Description

The present invention relates, in general, to an apparatus for and a method of measuring a power of a Radio Frequency (RF) signal or a Microwave Frequency (MF) signal using thermoelectric means.

The signal power of RF or MF systems ultimately determines the use and performance of the system. It is therefore necessary to accurately sense and measure the signal power of the system during its lifetime in order to monitor and assess its efficiency and performance. In order to sense and measure the signal power at radio or microwave frequencies, thermoelectric devices such as a thermistor or a thermocouple are typically employed to convert the power of an incident RF or MF signal into a measurable DC or low frequency signal.

Thermistor sensors are normally mounted within either coaxial or waveguide structures compatible with common transmission line systems used for RF or MF signals. A resistive element, for example, a 50 Ohm resistor contained within a thermal conducting block is used to dissipate power from an incident RF or MF signal to a thermistor device in the form of heat. The thermistor device is therefore disposed in close, thermal contact with the resistive element. In operation, the thermistor device is maintained at a constant resistance by means of a DC or low frequency AC bias. As the power of an incident RF or MF signal is dissipated to the thermistor device its resistance falls. As the resistance of the thermistor device falls, the bias supplied to the thermistor device is reduced by a corresponding amount in order to keep the resistance of the thermistor device constant. The decrease in bias supplied is therefore proportional to the power of an incident RF or MF signal and, following calibration, this relationship provides the user with a measurement of the power of the incident RF or MF signal.

A thermocouple sensor is a semiconductor device also comprising a resistive element, for example, a thin film resistor. The resistive element is disposed in intimate contact with a silicon chip having 'hot' and 'cold' junctions manufactured from suitable materials known in the art to form the thermocouple device. In operation, the resistive element converts the power of an incident RF or MF signal into heat which is conducted to the chip thereby forming a thermal gradient across the thermocouple device. The thermal gradient in turn gives rise to a thermoelectric potential difference. The thermoelectric potential difference provides a DC output voltage, the amplitude of which is proportional to the power of the incident RF or MF signal and following calibration, this relationship provides the user with a measurement of the power of the incident RF or MF signal.

As discussed above, known thermoelectric sensors comprise a resistive element to detect the RF or MF signal and dissipate the power of the RF or MF signal to a thermistor or thermocouple device as appropriate. The sensitivity and response time of such thermoelectric devices is therefore dependent upon the efficiency of the resistive element in dissipating power to the thermoelectric device. Known thermoelectric devices may suffer from 'thermal lag'; a condition which increases response time, that is, the time taken for the power of the incident RF or MF signal to be dissipated to the thermoelectric device by way of conduction. Furthermore, as it is only power dissipated to the thermoelectric device which provides the user with a power reading, any losses incurred by inefficient conduction from the resistive element to the thermoelectric device can result in inaccurate power measurements. High frequency modern communications networks push such known thermoelectric devices to their operating limits whilst also demanding flexibility and compatibility of the thermoelectric devices with a range of electronic and communications measurement applications.

According to a first aspect of the present invention, there is provided an apparatus for the measurement of a power of an RF or MF signal, the apparatus comprising a resistive element for generating a thermal emission in response to an RF or MF signal incident thereon; characterised in that an infra-red photodetector is arranged for detection of the thermal emission generated by the resistive element and for generation of an output signal corresponding to the power of the incident RF or MF signal.

Preferably, amplification means are coupled to the infra-red photodetector to receive, when in use, the output signal and thereby generate an amplified signal.

Preferably, the infra-red photodetector and the resistive element are disposed within a substantially evacuated housing. More preferably, the substantially evacuated housing comprises an internally silvered surface.

Preferably, the resistive element is a thin film chip resistor.

According to a second aspect of the present invention, there is provided a method of measuring a power of an RF or MF signal, the method comprising the steps of: generating a thermal emission by a resistive element in response to an incident RF or MF signal; detecting the thermal emission by an infra-red photodetector to generate an output signal corresponding to the power of the incident RF or MF signal.

Preferably, the method further includes the step of: amplifying the output signal.

According to a third aspect of the present invention, there is provided a use of an infra-red photodetector for a measurement of an average power of an RF or MF signal.

The present invention therefore provides an apparatus and a method for the detection and measurement of the power of an RF of MF signal. At least some embodiments of the present invention provide increased sensitivity and a faster response time compared to thermoelectric detection and measurement apparatus known in the art. Some embodiments of the present invention also provide greater efficiency and accuracy in addition to providing flexibility and compatibility with a range of electronic and communications measurement applications.

At least one embodiment of the present invention will now be described, by way of example only, with reference to the accompanying drawings, in which:

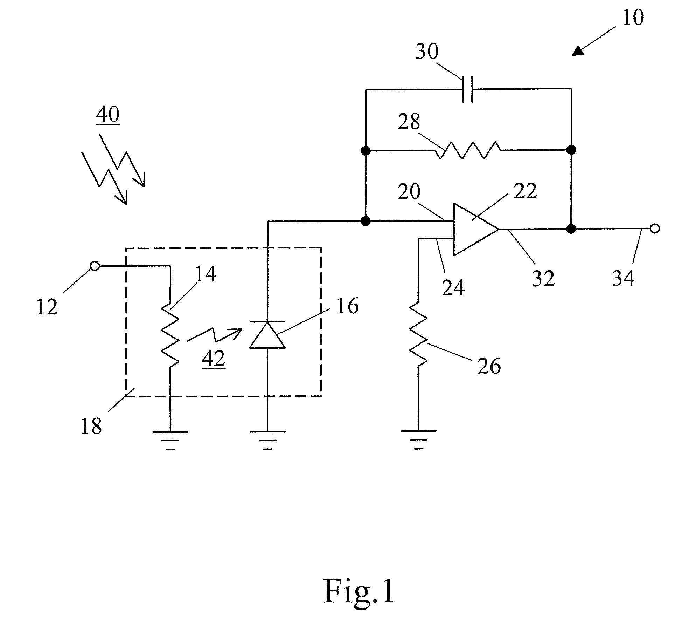

Figure 1 is a schematic diagram of one embodiment of an RF or MF power measurement and detector apparatus.

Referring to Figure 1, an RF or MF power measurement and detection apparatus 10 comprises an input port 12 such as a coaxial input connector coupled to a first terminal of a resistive element such as a 50 Ohm thin film chip load resistor 14 for generating a thermal emission, a second terminal of which is coupled to ground. A photodetector such as an infra-red photodiode 16 is disposed adjacent the load resistor 14 for detecting the thermal emission generated by the load resistor 14 when in operation. Both the load resistor 14 and the infra-red photodiode 16 are encapsulated within an evacuated housing 18. The evacuated housing 18 is constructed with an internally silvered surface (not shown) so as to minimise any loss of energy dissipated in the load resistor 14.

The evacuated housing 18 can be constructed using techniques typical to that of the construction of a filament lamp and the evacuated housing 18 is dimensioned to comprise both the load resistor 14 and the infra-red photodiode 16 therein.

An anode terminal of the infra-red photodiode 16 is coupled to ground and a cathode terminal of the infra-red photodiode 16 is coupled to a first input terminal 20 of an amplifier 22 such as a current feedback operational amplifier AD8014 as manufactured by Analog Devices. A second input terminal 24 of the amplifier 22 is coupled to a first terminal of a first resistor 26, a second terminal of which is coupled to ground. The cathode terminal of the infra-red photodiode 16 is also coupled to a first terminal of a feedback resistor 28 and a first terminal of a first capacitor 30. A second terminal of the first capacitor 30 and a second terminal of the feedback resistor 28 are coupled to an output terminal 32 of the amplifier 22. The first capacitor 30 and the feedback resistor 28 are disposed in parallel circuit configuration with respect to each other. The output terminal 32 of the amplifier 22 is coupled to an output port 34 such as a coaxial style connector.

In operation, an RF or MF signal 40 is incident upon the load resistor 14 and, in response to the power of the incident signal 40, the load resistor 14 dissipates power by way of thermal emissions 42. The thermal emissions 42 generated by the load resistor 14 are detected by the infra-red photodiode 16 so as to generate an output signal corresponding to the power of the incident signal 40 in the form of, for example, a photocurrent. The output signal generated by the infra-red photodiode 16 is received by the amplifier 22 in order to linearise the response of the infra-red photodiode 16 and provide an amplified signal having a wide dynamic range. The amplified signal corresponding to the power of the incident RF or MF signal is applied to the output port 34 and provides the user with a measurement of the power of the incident signal 40.

As the infra-red photodiode 16 and the load resistor 14 are disposed within an evacuated housing 18, external sources of electromagnetic radiation, convection and conduction are obviated or at least mitigated from affecting measurements as any such external sources are substantially prevented from modifying the "effective power" in the load resistor 14, that is, the power of the signal, incident upon the load resistor 14. Furthermore, as the infra-red photodiode 16 measures energy radiated by the load resistor 14, thermal lag is obviated or at least mitigated as thermal conduction from the resistive element to a thermoelectric device is not required.

It should be appreciated that, whilst the above description refers to a "power", the term "average power" is commonly used in the art for specifying the power of RF or MF signals. Average power is the power of the signal integrated over time, that is, integrated over many periods of the signal. The integration time (averaging time) for average power detection and measurement is typically from several hundredths of a second to several seconds. The term "power" is therefore intended to include reference to average power and, in a second embodiment of the present invention therefore, there is provided an apparatus and a method for the detection and measurement of the average power of an RF or MF signal.

## Claims

1. An apparatus (10) for the measurement of a power of an RF or MF signal, the apparatus comprising a resistive element (14) for generating a thermal emission (42) in response to an RF or MF signal (40) incident thereon; **characterised in that** an infra-red photodetector (16) is arranged for detection of the thermal emission (42) generated by the resistive element (14) and for generation of an output signal corresponding to the power of the incident RF or MF signal.

2. An apparatus as claimed in Claim 1, wherein amplification means (22) are coupled to the infra-red photodetector (16) to receive, when in use, the output signal and thereby generate an amplified signal.

3. An apparatus as claimed in Claim 1 or Claim 2, wherein the infra-red photodetector (16) and the resistive element (14) are disposed within a substantially evacuated housing (18).

4. An apparatus as claimed in Claim 3, wherein the substantially evacuated housing (18) comprises an internally silvered surface.

5. An apparatus as claimed in any preceding claim, wherein the resistive element (14) is a thin film chip resistor.

6. A method of measuring a power of an RF or MF signal, the method comprising the steps of:
generating a thermal emission (42) by a resistive element (14) in response to an incident RF or MF signal;
detecting the thermal emission (42) by an infra-red photodetector to generate an output signal corresponding to the power of the incident RF or MF signal.

7. A method as claimed in Claim 5, further comprising the step of:
amplifying the output signal.

8. A use of an infra-red photodetector for a measurement of an average power of an RF or MF signal.
